# EUROPÄISCHE PATENTANMELDUNG

(11) **EP 1 306 887 A1**
(43) Veröffentlichungstag der Anmeldung: **02.05.2003**
(21) Anmeldenummer: 01125776.3
(22) Anmeldetag: 29.10.2001
(51) Int. Cl.: H01L 21/00, B05C 5/02

(54) **Dispensdüse und Verfahren zum Auftragen von Klebstoff**

(71) Anmelder: Esec Trading S.A., 6330 Cham (CH)
(72) Erfinder: Ulrich, René Josef, 6353 Weggis (CH)
(74) Vertreter: Falk, Urs, Dr.

(57) **Zusammenfassung**

Für die Montage von kleinen Halbleiterchips wurden eine neue Düse (1) und ein neues Verfahren für das Auftragen von Klebstoff (14) auf ein Substrat (2) entwickelt. Die Düse wird während des Auftragens auf das Substrat abgesetzt. Die Düse besteht im wesentlichen aus einem länglichen Körper (3) mit einer Längsbohrung (4) und weist in ihrer dem Substrat zugewandten Stirnseite (6) vier Schlitze (7-10) auf, die von der Längsbohrung nach aussen in Richtung der gedachten Ecken des zu montierenden Halbleiterchips (12) führen. Die Längsbohrung ist, fakultativ, im Mündungsbereich aufgeweitet. Das Auftragen des Klebstoffes auf das Substrat erfolgt gemäss den folgenden Schritten:
1. Die Düse wird abgesenkt, bis ihre Stirnseite das Substrat berührt bzw. auf dem Substrat aufliegt.
2. Die Düse wird mit einem Druckpuls beaufschlagt, um eine vorbestimmte Menge an Klebstoff auszustossen. Der Klebstoff wird dabei durch die Schlitze gepresst, wobei die Luft durch die Schlitze entweichen kann.
3. Die Düse wird angehoben, wobei sich der Klebstoff von der Düse löst.

## Beschreibung

Die Erfindung betrifft eine Dispensdüse und ein Verfahren zum Auftragen von Klebstoff auf ein mit einem Halbleiterchip zu bestückendes Substrat.

Bei der Montage von Halbleiterchips werden sehr häufig Klebstoffe auf Epoxy-Basis verwendet, um den Halbleiterchip auf einem Substrat zu befestigen. Der Klebstoff muss so auf das Substrat aufgetragen werden, dass beim nachfolgenden Aufsetzen des Halbleiterchips eine möglichst gleichmässig über die ganze Chipfläche verteilte, von Lufteinschlüssen freie Klebstoffschicht entsteht. Im Idealfall ertreckt sich die Klebstoffschicht seitlich bis über die Kanten des Halbleiterchips hinaus und umschliesst auch die Ecken des Halbleiterchips vollständig. Zudem darf kein Klebstoff auf die Oberfläche des Halbleiterchips mit den elektronischen Schaltkreisen gelangen. Um dies zu erreichen, kommen je nach Chipformat, Klebstoffsorte und weiteren Parametern verschiedene "figürliche" Auftragsmuster zur Anwendung, die vom einfachen Diagonalenkreuz bis zu mehrfach verzweigten Strichfiguren reichen.

Um solche figürliche Muster aufzutragen, sind grundsätzlich zwei Verfahren bekannt. Beim ersten, z.B. aus der europäischen Patentanmeldung EP 928 637 bekannten Verfahren erfolgt das Auftragen mittels einer mit einer Vielzahl von Austrittsöffnungen ausgebildeten Düse. Die Austrittsöffnungen der Düse befinden sich auf einer vorbestimmten Höhe über dem Substrat. Die benötigte Klebstoffmenge wird mittels eines Druckpulses ausgestossen. Dabei hängt die Form der ausgestossenen Klebstoffmenge vom Abstand zwischen der Düse und dem Substrat ab. Beim zweiten, z.B. aus der europäischen Patentanmeldung EP 901 155 bekannten Verfahren erfolgt das Auftragen mittels einer an einem Schreibkopf befestigten Einzeldüse. Der Schreibkopf wird in einer entsprechend dem gewünschten Klebstoffmuster programmierten Bewegung über das Substrat geführt und "zeichnet" dabei das Klebstoffmuster.

Diese beiden Verfahren eignen sich für die Montage von Halbleiterchips, deren Abmessungen mindestens 2 mm ∗ 2 mm betragen. Bei Halbleiterchips mit kleineren Abmessungen treten hingegen Probleme auf, die dazu führen, dass sich der Klebstoff nicht gleichmässig unter dem Halbleiterchip verteilt und/oder dass sich unter den Ecken des Halbleiterchips kein Klebstoff befindet.

Der Erfindung liegt die Aufgabe zugrunde, eine Technologie für das Auftragen von Klebstoff zu entwickeln, mit dem sich auch bei Halbleiterchips, deren Abmessungen weniger als 2 mm ∗ 2 mm betragen, eine gleichmässige, reproduzierbare Verteilung des Klebstoffs unter dem Halbleiterchip erreichen lässt.

Die genannte Aufgabe wird erfindungsgemäss gelöst durch die Merkmale des Anspruchs 1.

Das Auftragen des Klebstoffes auf das Substrat erfolgt erfindungsgemäss mit einer neuartigen Düse, die während des Auftragens auf das Substrat abgesetzt wird. Die Düse besteht im wesentlichen aus einem länglichen Körper mit einer Längsbohrung und weist in ihrer dem Substrat zugewandten Stirnseite vier Schlitze auf, die von der Längsbohrung nach aussen in Richtung der gedachten Ecken des zu montierenden Halbleiterchips führen. Die Längsbohrung ist, fakultativ, im Mündungsbereich aufgeweitet. Das Auftragen des Klebstoffes auf das Substrat erfolgt gemäss den folgenden Schritten:
1. Die Düse wird abgesenkt, bis ihre Stirnseite das Substrat berührt bzw. auf dem Substrat aufliegt.
2. Die Düse wird mit einem Druckpuls beaufschlagt, um eine vorbestimmte Menge an Klebstoff auszustossen. Der Klebstoff wird dabei durch die Schlitze gepresst, wobei die Luft durch die Schlitze entweichen kann.
3. Die Düse wird angehoben, wobei sich der Klebstoff von der Düse löst.

Die auf dem Substrat abgesetzte Klebstoffportion hat die Form eines "x". Damit der Klebstoff nach erfolgter Montage des Halbleiterchips dessen Kanten und Ecken vollständig umsäumt, muss das "x" der Klebstoffportion grösser sein als der Halbleiterchip.

Als Material für die Düse können grundsätzlich alle bekannten Werkstoffe wie Stahl, Hartmetall, Aluminium, etc. verwendet werden. Um jedoch einen Abdruck der Düse auf dem Substrat zu vermeiden, besteht die Düse vorzugsweise aus einem gegenüber Metall elastischeren Material wie Kunststoff, z.B. dem als Vespel bezeichneten Kunststoff.

Nachfolgend wird ein Ausführungsbeispiel der Erfindung anhand der Zeichnung näher erläutert.

Es zeigen:
- Fig. 1: im Querschnitt eine Düse mit einer mit Schlitzen versehenen Stirnseite zum Auftragen von Klebstoff auf ein Substrat,
- Fig. 2: die Stirnseite der Düse in Aufsicht,
- Fig. 3: die auf dem Substrat deponierte Klebstoffportion und die Solllage eines auf dem Substrat zu montierenden Halbleiterchips,
- Fig. 4: den auf dem Substrat montierten Halbleiterchip in Aufsicht,
- Fig. 5: den auf dem Substrat montierten Halbleiterchip im Schnitt, und
- Fig. 6 - 8: drei Momentaufnahmen während des Auftragens des Klebstoffs.

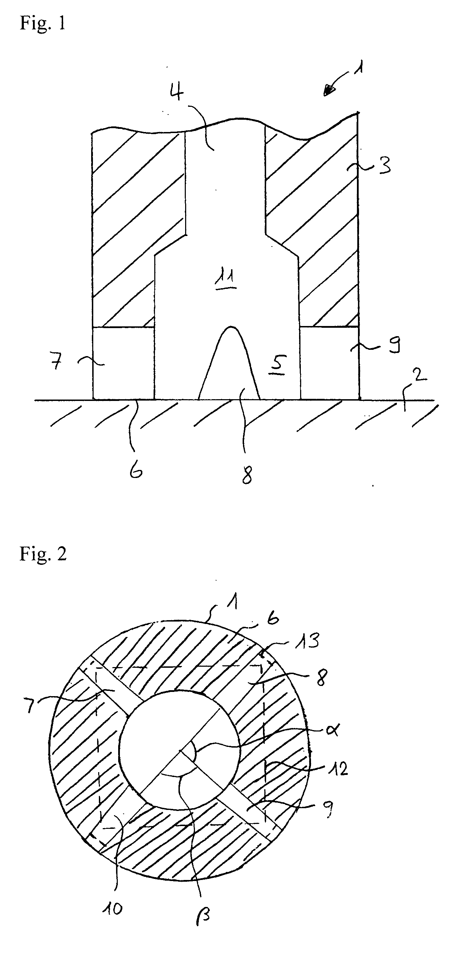

Die Fig. 1 zeigt im Querschnitt eine Düse 1 zum Auftragen von Klebstoff auf ein Substrat 2. Die Düse 1 besteht aus einem länglichen Körper 3 mit einer Längsbohrung 4, durch die der Klebstoff bis zu einer einzigen Austrittsöffnung 5 befördert wird. Der Körper 3 bildet somit eine die Austrittsöffnung 5 seitlich begrenzende Wand. Diese Wand weist eine flache Stirnseite 6 auf. Die Stirnseite 6 ist mit vier Schlitzen 7 bis 10 versehen, die vom Zentrum der Austrittsöffnung 5, d.h. von der Längsbohrung 4, nach aussen in Richtung der gedachten Ecken des zu montierenden Halbleiterchips führen (siehe Fig. 2). Die Schlitze 7 bis 10 sind bevorzugt als v-förmige Vertiefung ausgebildet. Die Schlitze 7 bis 10 können eine konstante Breite oder, wie dargestellt, eine sich nach aussen verjüngende Breite haben. Wenn die Düse 1 mit ihrer Stirnseite 6 auf dem Substrat 2 aufliegt, dann stellen die Schlitze 7 bis 10 nach aussen führende Kanäle dar, durch die Luft entweichen kann und durch die Klebstoff bis zu den gedachten Ecken des Halbleiterchips gepresst werden kann. Im Bereich der Austrittsöffnung 5 ist die Längsbohrung 4, fakultativ, aufgeweitet, so dass die Längsbohrung 4 in einen nach unten offenen, verbreiterten Hohlraum 11 mündet.

Die Fig. 2 zeigt die Stirnseite 6 der Düse 1 und den gedachten Halbleiterchip 12. Aus Kostengründen ist die Düse 1 bevorzugt zylinderförmig und die Stirnseite 6 somit kreisförmig. Der Durchmesser D der Stirnseite 6 ist grösser als die grösste Abmessung des Halbleiterchips 12, so dass die Ecken des Halbleiterchips 12 bei ideal gedachter Montage über den Schlitzen 7 bis 10 liegen: Die Winkel α bzw. β, die je zwei der Schlitze7 bis 10 einschliessen, sind somit gleich den Winkeln, die die Diagonalen des Halbleiterchips 12 einschliessen. Die Fig. 2 zeigt auch die Grenzen 13, die der Klebstoff mindestens erreichen muss, damit sich der Klebstoff bei der nachfolgenden Montage des Halbleiterchips 12 gleichmässig unter dem Halbleiterchip 12 verteilt und einen die Kanten und Ecken des Halbleiterchips 12 umschliessenden Saum bildet.

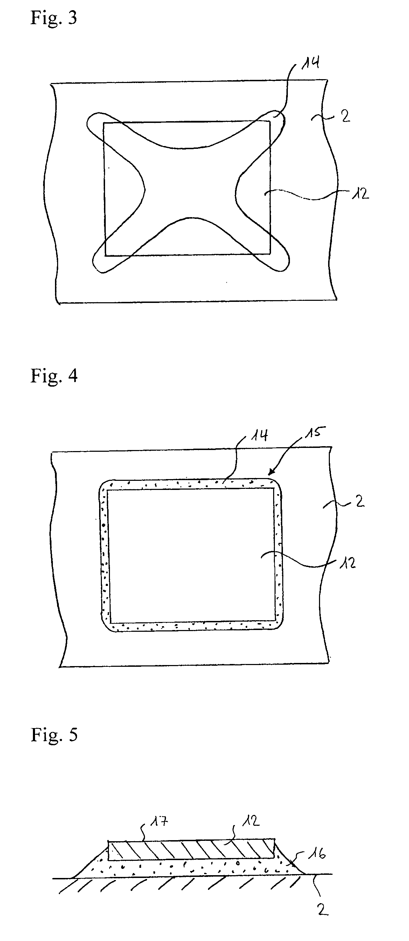

Die Fig. 3 zeigt den auf dem Substrat 2 deponierten Klebstoff 14 sowie die Solllage des zu montierenden Halbleiterchips 12. Die deponierte Klebstoffportion 14 erstreckt sich über die Ecken des Halbleiterchips 12 hinaus. Die Fig. 4 zeigt den auf dem Substrat 2 montierten Halbleiterchip 12. Deutlich sichtbar ist der die Kanten und Ecken des Halbleiterchips 12 umschliessende Saum 15 des Klebstoffs 14. Die Fig. 5 zeigt den montierten Halbleiterchip 12 im Querschnitt. Der Klebstoff 14 bildet ein ideales Fillet 16, d.h. der Klebstoff 14 umschliesst die seitlichen Kantenflächen des Halbleiterchips 12, ohne dass Klebstoff 14 auf die Oberfläche 17 des Halbleiterchips 12 mit den elektronischen Schaltkreisen gelangt ist.

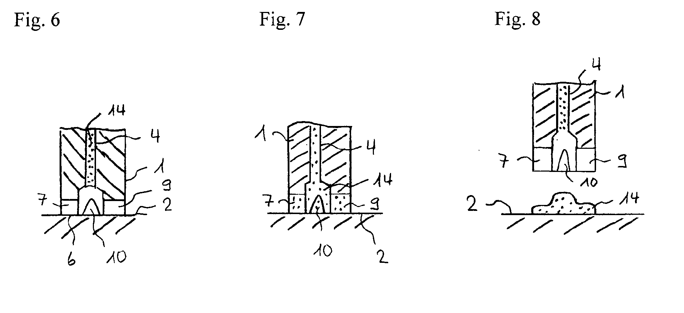

Die Fig. 6 bis 8 zeigen drei Momentaufnahmen während des Auftragens des Klebstoffs 14 auf das Substrat 2. In einem ersten Schritt wird die Düse 1 abgesenkt, bis ihre Stirnseite 6 das Substrat 2 berührt bzw. auf dem Substrat 2 aufliegt. Die Längsbohrung 4 ist mit Klebstoff 14 gefüllt. Dieser Zustand ist in der Fig. 6 dargestellt. Die Düse 1 wird nun mit einem Druckpuls beaufschlagt, um eine vorbestimmte Menge an Klebstoff 14 auszustossen. Der Klebstoff 14 wird dabei in die Schlitze 7 bis 10 gepresst, wobei die Luft durch die Schlitze 7 bis 10 entweichen kann. Der Zustand nach diesem zweiten Schritt ist in der Fig. 7 dargestellt. In einem dritten Schritt wird nun die Düse 1 angehoben, wobei sich der Klebstoff 14 von der Düse 1 löst und auf dem Substrat 2 zurückbleibt. Der Klebstoff 14 reisst in der Regel beim Übergang von der Längsbohrung 4 in den Hohlraum 11 ab. Der Zustand nach diesem dritten Schritt ist in der Fig. 8 dargestellt.

Im folgenden seien einige Abmessungen der Düse an einem typischen Beispiel zahlenmässig erläutert. Die Abmessungen des Halbleiterchips 12 betragen 0.85 mm * 1 mm. Der Durchmesser der Längsbohrung 4 beträgt 0.4 mm. Der Durchmesser der Längsbohrung 4 ist im Mündungsbereich auf 0.55 mm erweitert. Die Breite der Schlitze 7 bis 10 beträgt 0.3 mm, ihre Tiefe 0.36 mm.

Durch Variationen der Breite der Schlitze 7 bis 10 und das Mass der Aufweitung der Längsbohrung 4 im Bereich der Austrittsöffnung 5 kann erstens die Menge des aufzutragenden Klebstoffes 14 sowie das Verhältnis der Menge des in der Mitte ausgestossenen Klebstoffes zur Menge des in die Schlitze ausgestossenen Klebstoffes aufeinander abgestimmt werden.

Die Düse ist vorzugsweise federnd an einem Dispenskopf gelagert, damit sie beim Absenken des Dispenskopfes beim Auftreffen auf dem Substrat gegenüber dem Dispenskopf ausgelenkt wird. Auf diese Weise werden Abdrücke im Substrat vermieden oder zumindest reduziert.

Die erfindungsgemässe Düse und das erfindungsgemässe Verfahren bieten mehrere Vorteile:
- Der Klebstoff ist gleichmässig und ohne Lufteinschlüsse unter dem Halbleiterchip 12 verteilt.
- Die Dicke der Klebstoffschicht zwischen dem Substrat 2 und dem Halbleiterchip 12 ist annähernd konstant, d.h. eine allfällige Schräglage des Halbleiterchips 12 ist sehr gering.
- Der Klebstoff umsäumt Kanten und Ecken des Halbleiterchips 12.
- Schwankungen der Dicke der Klebstoffschicht sind sehr gering, was auch neue Anwendungsmöglichkeiten eröffnet: Bei einer speziellen Anwendung im Bereich der Mobiltelefone bilden eine Elektrode auf dem Substrat und eine Elektrode auf dem Halbleiterchip einen Kondensator. Deshalb wird hier eine hohe Reproduzierbarkeit und Konstanz der Schichtdicke verlangt.
- Die Verteilung des Klebstoffes auf dem Substrat wird nicht mehr durch den effektiven Abstand zwischen Substrat und Düse bestimmt, sondern durch die geometrische Form der Düse im Bereich der Austrittsöffnung.

## Patentansprüche

1. Verfahren zum Auftragen von Klebstoff (14) auf ein mit einem Halbleiterchip (12) zu bestückendes Substrat (2), wobei der Klebstoff (14) über eine Düse (1) ausgestossen wird, wobei die Düse (1) eine einzige Austrittsöffnung (5) aufweist, die durch eine Wand begrenzt ist, **dadurch gekennzeichnet, dass** eine Stirnseite (6) der Wand, die die Austrittsöffnung (5) begrenzt, vier Schlitze (7-10) umfasst, die von der Austrittsöffnung (5) nach aussen führen, dass die Düse (1) abgesenkt und auf dem Substrat (2) aufgesetzt wird, so dass die Stirnseite der Düse (1) auf dem Substrat (2) aufliegt, dass die Düse (1) mit einem Druckpuls beaufschlagt wird, so dass die Schlitze (7-10) mindestens teilweise mit Klebstoff gefüllt werden, und dass die Düse (1) abgehoben wird.

2. Verfahren nach Anspruch 1, **dadurch gekennzeichnet, dass** die vier Schlitze (7-10) vom Zentrum der Austrittsöffnung (5) in Richtung der gedachten Ecken des Halbleiterchips (12) führen.

3. Verfahren nach Anspruch 1 oder 2, **dadurch gekennzeichnet, dass** die Wand mit den Schlitzen (7-10) aus Kunststoff besteht.

4. Düse (1) zum Auftragen von Klebstoff auf ein mit einem Halbleiterchip (12) zu bestückendes Substrat (2), die eine einzige Austrittsöffnung (5) aufweist, die durch eine Wand begrenzt ist, **dadurch gekennzeichnet, dass** eine Stirnseite (6) der Wand, die die Austrittsöffnung (5) begrenzt, vier Schlitze (7-10) umfasst, die von der Austrittsöffnung (5) nach aussen führen.

5. Düse nach Anspruch 4, **dadurch gekennzeichnet, dass** die vier Schlitze (7-10) vom Zentrum der Austrittsöffnung (5) in Richtung der gedachten Ecken des Halbleiterchips (12) führen.

6. Düse nach Anspruch 4 oder 5, **dadurch gekennzeichnet, dass** die Wand mit den Schlitzen (7-10) aus Kunststoff besteht.
